(19) Europäisches Patentamt
European Patent Office
Office européen des brevets

(11) **EP 3 633 858 A1**

(12) **EUROPEAN PATENT APPLICATION**
published in accordance with Art. 153(4) EPC

(43) Date of publication:
**08.04.2020 Bulletin 2020/15**

(51) Int Cl.:
***H03M 13/15*** (2006.01)       ***H03M 13/11*** (2006.01)

(21) Application number: **18809224.1**

(22) Date of filing: **20.04.2018**

(86) International application number:
**PCT/CN2018/083957**

(87) International publication number:
**WO 2018/219064 (06.12.2018 Gazette 2018/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **31.05.2017 CN 201710401631**

(71) Applicant: **China Academy of
Telecommunications Technology
Hai Dian District
Beijing 100191 (CN)**

(72) Inventors:
• **WANG, Jiaqing
  Beijing 100191 (CN)**
• **ZHANG, Di
  Beijing 100191 (CN)**
• **SUN, Shaohui
  Beijing 100191 (CN)**

(74) Representative: **Nony
11 rue Saint-Georges
75009 Paris (FR)**

(54) **METHOD AND DEVICE FOR DETERMINING CHECK MATRIX, AND COMPUTER STORAGE MEDIUM**

(57)     Disclosed in the present application are a method and device for determining a check matrix, as well as a computer storage medium, which are configured to provide a structural solution for a high-throughput low-delay low-density parity check (LDPC) check matrix suitable for a 5G system. A method for determining a check matrix as provided in an embodiment of the present application comprises: determining a base graph of a low-density parity check code LDPC matrix, and according to the base graph of the LDPC matrix, determining a check matrix of the LDPC.

Determining a base graph of a low-density
parity check code (LDPC) matrix — S101

Determining a check matrix of the LDPC
according to the base graph of the LDPC matrix — S102

Fig. 6

EP 3 633 858 A1

# Description

This application claims priority of China Patent Application No. 201710401631.8, filed with the Patent Office of the People's Republic of China on May 31, 2017 and entitled "Method and Device for Determining Check Matrix, and Computer Storage Medium", which is incorporated in this application by reference in its entirety.

## Field

The application relates to the field of communication technology, particularly relates to a method and device for determining a check matrix, and a computer storage medium.

## Background

Currently, the 3rd Generation Partnership Project (3GPP) proposes that the channel coding design of a Low Density Parity Check Code (LDPC) should be given for the 5G Enhanced Mobile Broadband (eMBB) scenario.

The LDPC is a kind of linear code defined by a check matrix. In order to make decoding feasible, the check matrix needs to satisfy the sparsity when the code length is long, which means that the density of 1 in the check matrix is low, that is, the number of 1 in the check matrix is far less than that of 0, and the longer the code length is, the lower the density will be.

However, the structural solution for an LDPC check matrix suitable for a 5G system is not given in the related art.

## Summary

Some embodiments of this application provide a method and device for determining a check matrix, and a computer storage medium, which are configured to provide a structural solution for a high-throughput low-delay LDPC check matrix suitable for a 5G system.

A method for determining a check matrix provided in some embodiments of the present application includes:

> determining a base graph of a low-density parity check code (LDPC) matrix;
> determining a check matrix of the LDPC according to the base graph of the LDPC matrix.

According to the method for determining the check matrix provided in some embodiments of this application, the base graph of the LDPC matrix is determined, and the check matrix of the LDPC is determined according to the base graph of the LDPC matrix. Thus, the structural solution for the high-throughput low-delay LDPC check matrix suitable for a 5G system can be provided.

Optionally, the determining a check matrix of the LDPC according to the base graph of the LDPC matrix includes:

> determining circulation coefficients of sub-circular matrices according to the base graph of the LDPC matrix.

> conducting dispersion operation on a protoMatrix by using the circulation coefficients of the sub-circular matrices to obtain the check matrix of the LDPC.

Optionally, determining a base graph of an LDPC matrix includes:
determining a base graph of an LDPC matrix according to a preset quantity of rows and columns.

Optionally, the base graph of the LDPC matrix includes base graphs with multiple code rates, and base graphs with different code rates have different structures.

Optionally, the determining a base graph of an LDPC matrix according to the preset quantity of rows and columns includes:

> generating a base graph of a non-row orthogonal structure with a preset row weight according to a first code rate;
> generating a base graph of a quasi-row orthogonal structure by enabling the base graph of the non-row orthogonal structure to extend according to a second code rate;
> generating a base graph of a row orthogonal structure by enabling the base graph of the quasi-row orthogonal structure to extend according to a third code rate;
> constituting a base graph of an LDPC matrix satisfying preset requirements of row number and column number by the base graph of the non-row orthogonal structure, the base graph of the quasi-row orthogonal structure and the base graph of the row orthogonal structure;
> wherein, the first code rate is larger than the second code rate, and the second code rate is larger than the third code rate.

Optionally, in the base graph, a row weight of all rows in the base graph corresponding to the bidiagonal matrix is greater than or equal to a preset value.

A device for determining a check matrix provided in some embodiments of the present application includes:

> a first unit configured to determine a base graph of an LDPC matrix.
> a second unit configured to determine a check matrix of the LDPC according to the base graph of the LDPC matrix.

Optionally, the second unit is configured to:

determine circulation coefficients of sub-circular matrices according to the base graph of the LDPC matrix;

conduct a dispersion operation on a protoMatrix by using the circulation coefficients of the sub-circular matrices to obtain the check matrix of the LDPC.

Optionally, the first unit is configured to: determine a base graph of an LDPC matrix according to a preset quantity of rows and columns.

Optionally, the base graph of the LDPC matrix includes base graphs with multiple code rates, and base graphs with different code rates have different structures.

Optionally, the first unit is configured to:

generate a base graph of a non-row orthogonal structure with a preset row weight according to the first code rate;

generate a base graph of a quasi-row orthogonal structure by enabling the base graph of the non-row orthogonal structure to extend according to a second code rate;

generate a base graph of a row orthogonal structure by enabling the base graph of the quasi-row orthogonal structure to extend according to a third code rate;

constitute a base graph of an LDPC matrix satisfying preset requirements of row number and column number by the base graph of the non-row orthogonal structure, the base graph of the quasi-row orthogonal structure and the base graph of the row orthogonal structure;

wherein, the first code rate is larger than the second code rate, and the second code rate is larger than the third code rate.

Optionally, in the base graph, a row weight of all rows in the base graph corresponding to the bidiagonal matrix is greater than or equal to a preset value.

In another aspect, an encoding method provided in some embodiments of the present application includes:

encoding according to a check matrix of the LDPC; wherein the check matrix of the LDPC is determined by the above-mentioned method for determining a check matrix provided in some embodiments of this application.

In another aspect, an encoding device provided in some embodiments of the present application includes:

an encoding unit, which is configured to encoding according to a check matrix of the LDPC; wherein the check matrix of the LDPC is determined by the above-mentioned method for determining the check matrix provided in some embodiments of this application.

Another device for determining a check matrix provided in some embodiments of this application includes a memory and a processor, wherein the memory is configured to store program instructions, and the processor is configured to read the program instructions stored in the memory to execute any of the above-mentioned methods.

A computer storage medium provided in some embodiments of the present application stores computer executable instructions for enabling the computer to execute any of the above-mentioned methods.

**Brief** Description of **the** Drawings

In order to more clearly illustrate the technical solution in the embodiments of this application, a brief introduction will be given to the drawings used in the description of the embodiments. Obviously, the drawings described below are only some embodiments of this application, and further drawings can also be obtained from these drawings without creative work by those skilled in the art.

Fig. 1 is a structural schematic diagram of a Base matrix provided in some embodiments of the present application;

Fig. 2 is a structural schematic diagram of a matrix P provided in some embodiments of the present application;

Fig. 3 is a structural schematic diagram of a circular permutation matrix when z = 8 provided in some embodiments of the present application;

Fig. 4 is a structural schematic diagram of an LDPC check matrix supporting incremental redundancy provided in some embodiments of the present application;

Fig. 5 is a structural schematic diagram of the Base graph of (22, 32) provided in some embodiments of the present application;

Fig. 6 is a flowchart of a method for determining a check matrix provided in some embodiments of the present application;

Fig. 7 is a structural schematic diagram of a device for determining a check matrix provided in some embodiments of the present application;

Fig. 8 is a structural schematic diagram of another device for determining a check matrix provided in some embodiments of the present application.

**Detailed Description of the Embodiments**

Some embodiments of this application provide an encoding method and device, and a computer storage medium, which are used for improving the LDPC encoding performance, thereby being suitable for a 5G system.

The technical solution provided in some embodiments of this application provides LDPC encoding for a data channel in the eMMB scenario to replace turbo encoding for the original LTE (Long Term Evolution) system, i.e. an LDPC encoding solution suitable for a 5G system is provided.

The LDPC designed for 5G requires a quasi-circular LDPC to be adopted, and the check matrix H of the code can be expressed as follows:

$$H = \begin{bmatrix} A_{0,0} & A_{0,1} & \cdots & A_{0,c-1} \\ A_{1,0} & A_{1,1} & \cdots & A_{1,c-1} \\ \vdots & \vdots & \ddots & \vdots \\ A_{\rho-1,0} & A_{\rho-1,1} & \cdots & A_{\rho-1,c-1} \end{bmatrix}$$

wherein, the $A_{i,j}$ refers to a circular permutation matrix of $z \times z$.

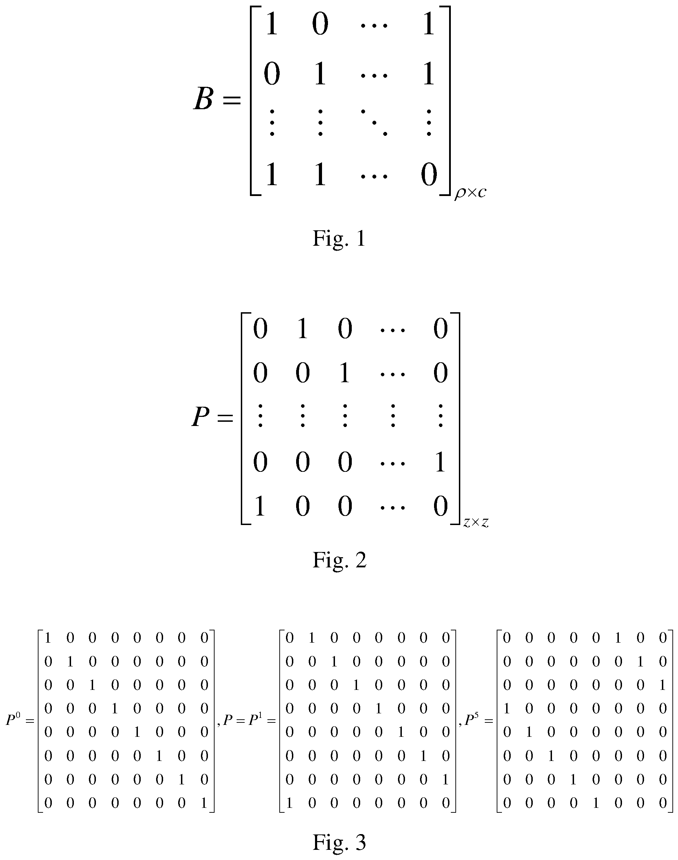

There are many ways to construct a quasi-circular LDPC. For example, first, a Base matrix B of $\rho \times c$ with elements of either 0 or 1 is constructed, as shown in Fig. 1; then each element 1 in the Base matrix B is extended to a Circular Permutation Matrix (CPM) of $z \times z$, and element 0 in the Base matrix is extended to an all-0 matrix of $z \times z$. The Base matrix B is called base graph in the later proto-based LDPC construction. $P^i$ is configured to represent each circular permutation matrix of $z \times z$, wherein the matrix P is a matrix obtained by the unit matrix circularly shifting one place to the right, as shown in Fig. 2, and i is the circularly shifting label, i.e. the circulation coefficient of the sub-matrix. Fig. 3 gives an example of a circular permutation matrix $P^i$ (sub-grouping size is $8 \times 8$, that is Z = 8).

Therefore, each circular permutation matrix $P^i$ actually stands for i times of circularly shifting of unit matrix I to the right, and the shifting label i of the circular permutation matrix satisfies $0 \leq i < z, i \in \not c$. In order to obtain various code lengths, sizes z of the circular permutation matrix are taken as 27, 54 and 81 respectively, corresponding to the three code lengths of 1944, 1296 and 648.

The sub-circular permutation matrix (CM) corresponding to the quasi-circular LDPC described above may have the column weight being greater than 1, for example, the column weight is 2 or a value greater than 2, and then the sub-circular permutation matrix is no longer a CPM.

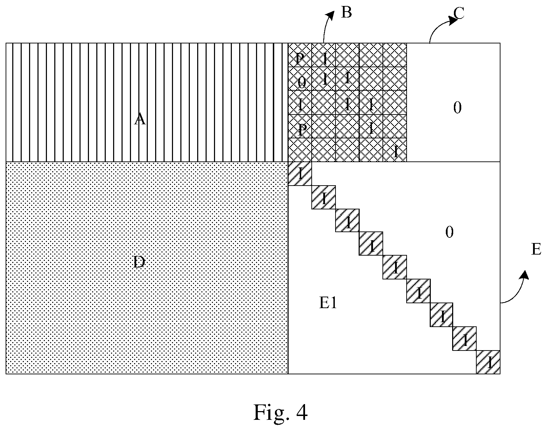

The LDPC designed for 5G must support IR (Incremental redundancy) - HARQ (Hybrid Automatic Repeat Request). Therefore, the LDPC for a 5G scenario can be constructed by incremental redundancy. That is, first, an LDPC with high code rate is constructed, then incremental redundancy is adopted to generate more check bits, and further an LDPC with low code rate can be obtained. The LDPC constructed based on incremental redundancy has many advantages, such as excellent performance, wide code length and code rate coverage, high reusability, easy implementation through hardware, and capability of being directly encoded by a check matrix. An example of the specific structure is shown in Fig. 4, wherein B is a bidiagonal or quasi-bidiagonal matrix, C is a 0 matrix and E is a lower triangular extending matrix. The design of the check matrix of the LDPC mainly depends on the design of A, D and E1.

The performance of the LDPC depends on two most important factors, one is the design of the base matrix, and the other is how to extend each non-zero element in the base matrix into a circular permutation matrix of $z \times z$. These two factors play a decisive role in the performance of the LDPC.

In summary, a 5G communication system has an important need, compared with LTE, to greatly improve the data rate in eMBB scenarios. The downlink requires 20Gbps throughput, while uplink requires 10Gbps throughput. In order to effectively support the throughput requirements, the LDPC parameters adopted in the eMBB data channel are defined as follows: the maximum code rate is not less than 8/9, the maximum code length is 8488, and the maximum dimension Zmax of the circular sub-matrix that determines the decoding parallelism of the LDPC is equal to 384. The current design parameters for the LDPC with 8/9 code rate have no problem in supporting 20Gbps, but there are some problems in practical application as follows: first, with the decreasing of the code rate, the throughput of a 5G LDPC decoder should be able to achieve performance at least comparable to that of LTE turbo codes. For example, assuming that turbo has a maximum downlink throughput of 1Gbps at 8/9 code rate, 750 Mbps at 2/3 code rate, then LDPC throughput designed for a 5G downlink should be at least 15 Gbps at 2/3 code rate. At the same time, LDPC with R=8/9 code rate supports 10/20 Gbps throughput for upper/downlink respectively. The maximum code rate should be an entry condition, and retransmitting should be considered. The retransmitting code rate of the LDPC with incremental redundancy must be lower than the initial transmitting code rate, but with the lowering of code rate, the check matrix of the LDPC grows rapidly, for example, assuming the base graph dimension of LDPC with 8/9 code rate is 10 rows and 90 columns, the base graph of the LDPC with 1/2 code rate will be changed to 45 rows and 90 columns. With the rising of the row number of the check matrix of the LDPC, the number of sides, i.e. the number of 1 in the matrix, also increases substantially. However, the number of sides is proportional to the latency of decoding of each block, so if only 8/9 code rate supports 20Gbps throughput, greater latency is required for the retransmitted low code rate, which makes it impossible to complete decoding at this time. Once it happens, the terminal will respond Negative Acknowledgement (NACK) signaling to the base station by packet-dropout, which will greatly reduce the throughput. Therefore, besides the highest code rate, LDPC designed for 5G needs to consider how to support 20Gbps throughput for lower code rate.

The 5G Ultra-Reliable and Low Latency Communication (URLLC) scenario emphasizes low latency and high reliability, so the to-be-designed LDPC must have ultra-low latency, thus it is hoped that the LDPC with low code rate has ultra-low latency too.

Therefore, the design structure of a 5G LDPC check matrix supporting low latency and high throughput is worth studying.

The parallelism of the LDPC is proportional to the dimension Z of sub-circular matrices. In order to improve throughput, all the rows of the LDPC are orthogonal. For example, the following is the base graph of four rows and eight columns (each 1 represents a sub-circular matrix of $Z \times Z$):

$$\begin{bmatrix} 1 & 0 & 0 & 0 & 1 & 0 & 0 & 0 \\ 0 & 0 & 1 & 0 & 0 & 1 & 0 & 0 \\ 0 & 1 & 0 & 0 & 0 & 0 & 0 & 1 \\ 0 & 0 & 0 & 1 & 0 & 0 & 1 & 0 \end{bmatrix}$$

the four rows are orthogonal to each other for parallel processing at the same time, and the latency is reduced by four times as much as that of single row processing, which greatly improves throughput.

The parallelism is a hardware term. The decoder is divided into serial decoding and parallel decoding. For example, a turbo code of Wideband Code Division Multiple Access (WCDMA) can only be decoded serially, that is, after one bit is decoded, the other bit will be decoded at a very slow speed. When a Quadratic Permutation Polynomials (QPP) interleaver is introduced into an LTE-turbo code, turbo can be decoded in several segments simultaneously, that is, parallel decoding. The structure of the QPP interleaver has limited the synchronous decoding channels of turbo. The number of parallel decoding at the same time is called parallelism. The parallelism of LTE-turbo is low, and the parallelism of the LDPC depends on Z, for example, when Z = 256, there are 256 parallel decoding channels, and 256 is the parallelism.

However, in order to improve the performance of low SNR, the LDPC adopted by 5G adopts the structure in which the first two columns are built-in punching columns, that is, the information bits corresponding to the first and second columns of the base graph are not sent into the channel, but participate in the decoding. Since the signals sent by the first two columns are not actually transmitted, in order to successfully decode the first column and the second column of the base graph, and to assure high column weight of the first column and the second column, that is, the elements in the first column and the second column of the base graph are mostly 1, the high column weight provides high protection for the information bits that are not sent into the channel, so that the corresponding information bits can be decoded correctly even if they are not sent into the channel. In order to improve the throughput, if the row orthogonality is designed, the decoding of the first two columns that are not sent into the channel, of the base graph will not be successful and the performance of the LDPC will be greatly lost.

Therefore, a method for determining a 5G LDPC check matrix supporting low latency and high throughput is provided in some embodiments of this application, including the following steps.

Step 1: a whole base graph of the LDPC matrix is determined according to the number of rows and columns of the preset base graph.

The Base graph described in some embodiments of this application is in fact a matrix, which can also be called base matrix. As a matrix, the Base graph has rows and columns. Since the elements in the base graph are either 0 or 1, the row weight of any row described in some embodiments of this application is defined as the number of 1 in that row, and similarly, the column weight of any column is defined as the number of 1 in that column.

Specific steps are as follows.

a) base graph with high code rate adopts a non-row orthogonal structure with high row weight, and optionally, all rows in the base graph corresponding to the bidiagonal matrix in Fig. 4 adopt row weight greater than the preset value, which is related to the size of the base graph with high code rate; for example, the number of 1 in each row divided by the number of rows in the base graph with high code rate is greater than the preset value, and preferably, the preset value is 0.5. This design can ensure the high code rate performance of the LDPC. Of course, because the number of 1 in the base graph with high code rate is too large, there is no row orthogonal structure. The base graph with the highest code rate must be of a non-row orthogonal structure. The high code rate part, extending downward, of the highest code rate may still adopt a non-row orthogonal structure, but the row weight is smaller than that of the bidiagonal part.

The high code rate and low code rate described in some embodiments of this application are relative concepts. For example, code rate higher than 1/2 may be called high code rate. Similarly, code rate lower than 1/2 may be called low code rate, and medium code rate is 1/2 or so in general, but it is not absolute. 5G LDPC has two base graphs wherein the large base graph supports R = 8/9 to 1/3, and small base graph supports R = 2/3 to 1/5. For the large base graph, code rate of 8/9 or even 2/3 is high; for the small base graph, code rate of R = 2/3 is high, and code rate higher than 1/2 is also considered high. At least the code rate of rows corresponding to the bidiagonal structure is high, and there is not too much downward extending in the bidiagonal structure. R = 1/2 or higher are considered high code rate. The so-called low code rate is generally or preferably required to be less than 1/2.

The base graph with high code rate described in some embodiments of this application actually refers to the base graph corresponding to high code rate. Take the base graph of 42 rows and 52 columns as an example, i.e. the base graph with the lowest code rate of 1/5 (the selection will be explained later), as an example. First, the column number N of the check matrix in the LDPC (the check matrix is not the base graph, and is obtained by extending a circular permutation matrix by the base graph) minus the row number M (M corresponds to the number of check equations) is the number of information bit K=N-M. The unit of K is bit, and the code rate is the number of information bit divided by code length, that is, R=k/N; and the size difference between the base graph and the check matrix is equal to the multiple Z of the size of sub-circular matrix, so the base graph can be configured to directly settle information bit and code rate. Assuming that the column number of the base graph is Nb and the row number is Mb, then the column number corresponding to information bit is Kb = Nb-Mb. Note that here it uses Kb instead of K. The unit of K is bit, and the unit of Kb is the column number of the base graph. There is a Z-fold difference between the two from the point of view of bit. According to the base graph parameter, the code rate can be determined by R=Kb/Nb. Further, since the 5G base graph uses two built-in punching columns, which correspond to the first two columns of the base graph (of course, it is possible to locate either of them at any position in the corresponding column of base graph information bit), to improve the performance of low signal-to-noise ratio. The corresponding information bits of these two columns are not sent into the channel after being encoded, so the length of the information bits that are actually sent into the channel is Nb-2, not Nb, so for 5G LDPC, the information bit Kb = 52-42 = 10, R = 10/(52-2) = 1/5, and this is the calculation method of the bit rate of 1/5.

Then, for the base graph corresponding to high code rate, the high code rate is relative. If the base graph with high code rate of 22 rows and 32 columns has been constructed: similarly, kb = 32-22 = 10, R = 10/(32-2) = 1/3, the base graph of 22 rows and 32 columns according to R = 1/3 extends downward 20 rows and 20 columns to become the base graph of 42 rows and 52 columns with the low code rate of R = 1/5, and this is the source of constructing a base graph with low code rate according to a base graph with higher code rate.

For the high column weight, for example, the ratio of the number of 1 to the number of rows is larger than 0.5, which can be determined according to actual needs, and the column with more 1 has higher column weight.

b) medium and high code rate extended base graphs adopt a quasi-row orthogonal structure. Specifically, in the base graph corresponding to the extended medium and low code rate under the high code rate part of the non-row orthogonal structure in a base graph, the whole or grouped quasi-row orthogonal structure is adopted, that is, in the corresponding base graph, except that the first two columns maintain a non-orthogonal structure, other columns maintain whole or grouped row orthogonal structure.

c) low code rate extended base graphs adopt a row orthogonal structure. Specifically, in the base graph corresponding to the extended low code rate under the medium and high code rate part of the quasi-row orthogonal structure in a base graph, the whole or grouped row orthogonal structure is adopted, that is, in the corresponding base graph, all columns maintain the whole or grouped non-orthogonal structure, namely, these columns, even the first two columns, maintain a row orthogonal structure when extending to the base graph.

A base graph satisfying the preset quantity of rows and columns is constructed by the above-mentioned base graph of the non-row orthogonal structure, the base graph of the quasi-row orthogonal structure and the base graph of the row orthogonal structure.

The row orthogonality described in some embodiments of this application: the inner product between the row orthogonal rows is 0, namely, there is no overlapping 1;

the quasi-row orthogonality described in some embodiments of this application: specifically for 5G LDPC, means that each row has its all columns satisfying the inner product orthogonal condition except for column 1 and column 2;

the non-row orthogonality described in some embodiments of this application: means that neither the row orthogonality nor the quasi-row orthogonality is satisfied, and the orthogonality is the worst.

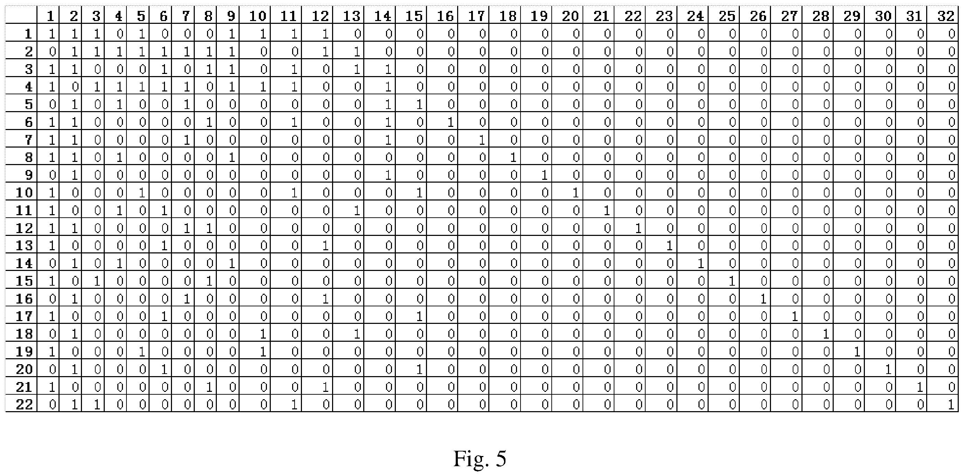

Embodiment 1: The size of the base graph is 22 rows and 32 columns, as shown in Fig. 5. The first two columns are built-in punching columns with high column weight. The two corresponding information bits are not transmitted in the channel at least at the first transmission, and the corresponding information bit is kb=32-22=10 columns, the lowest code rate is Rmin=10/(32-2)=1/3, the highest code rate belongs to the check matrix corresponding to the first 5 rows and 15 columns, the corresponding information bit is kb=15-5=10, Rmax=10/(15-2)=0.77. The first 5 rows and the first 15 columns constitute the highest code rate: R=(15-5)/(15-2)= 10/13, which is non-row orthogonal structure, and the bidiagonal matrix part has 4 rows and 14 columns. The row weight of each row in the base graph corresponding to the bidiagonal matrix is not less than the preset value, which can be set to half of the number of columns corresponding to the upper diagonal part, as shown in Fig. 5, the minimum row weight is 8 and is larger than half of the column number which is 7; the base graph of R = 10/13 extends downward 2 rows and 2 columns to become 7 rows and 17 columns to constitute a base graph with code rate of R=(17-7)/(17-2)=2/3. The extended two rows are still of non-row orthogonal structures, so base graphs corresponding to code rate till R = 2/3 are still of non-row orthogonal structures. The base graph with R=2/3 extends downward 5 rows and 5 columns to become 12 rows and 22 columns, and the 5 rows and 5 columns extended from the base graph with code rate of R=(22-12)/(22-2)=1/2 are obtained. The extended first three rows satisfy the quasi-row orthogonal relationship, and the extended last two rows also satisfy the quasi-row orthogonal relationship, but the first three rows and the last two rows do not satisfy the row orthogonal relationship. The base graph corresponding to code rate of 1/2 extends downward 10 rows and 10 columns to obtain a base graph with R=(32-22)/(32-2)=1/3. In the extended 10 rows, row 13-14, 14-15, 15-16, 17-18, 19-20 and 21-22 satisfy the orthogonal relationship.

Step 2: the circulation coefficients of the sub-circular matrices are determined according to the whole base graph of the LDPC matrix.

To determine the circulation coefficients of the sub-circular matrices, determining of the size Z of the sub-circular matrix is firstly needed. Different Zs correspond to different check matrices, as well as to different information bits. The 5G LDPC needs to adapt to the length from 40 to 8448 of information bits, so as to correspond to many Zs, for example, information bits K = 40 to 8448.

As for how to determine Z according to K, assuming that the base graph of K=1280 has Kb=10, then Z=1280/10=128, and if K=1290, then Z=2560/10=256, and K from 40 to 8448 necessarily needs a lot of Zs, and each Z corresponds to a check matrix.

In order to reduce the storage capacity of the circulation coefficients, it is necessary to adopt the same circulation coefficient or a function of a certain circulation coefficient for multiple Zs. Therefore, the design goal of the circulation coefficients is to make the circulation coefficients be suitable for multiple Zs by using the ring distribution as a measure and possess good ring distribution and minimum distance characteristics under different Zs. Wherein, the minimum distance is the smallest difference between two codewords. The larger the minimum distance is, the less likely the receiver will confuse. If the smallest distances are very small and all conform to HW=0, the check may be right, but the codewords may be not true.

The sub-circular matrix is introduced as follows: first, the check matrix of a quasi-circular LDPC is a binary matrix, wherein elements are either 0 or 1. The check matrix of M rows and N columns is composed of Mb-row and Nb-column sub-circular matrices, and the dimension of each sub-circular matrix is ZxZ. Therefore, the Mb-row and Nb-column is also called base graph. So, after obtaining the base graph, each 1 is needed to be extended into a circular permutation matrix, and each 0 is needed to be extended into a 0 matrix of ZxZ. From the whole check matrix, it is not a circular permutation matrix, but from every sub-matrix, it is circular, and that is the source of the definition of the sub-circular matrix.

The circulation coefficient of sub-circular matrix is introduced as follows: since each 1 in the base graph is needed to be extended into a circular permutation matrix, the circular permutation matrix actually depends on the first row, and the position of 1 in the first row is the circulation coefficient of the circular permutation matrix. According to the definition in this application, the circulation coefficient of unit matrix refers to the position number of 1 in the first row, which, as should be noted, is the index started from 0.

The check matrix is introduced as follows: first, a linear block code needs a binary matrix H, which is called check matrix. By using this matrix, information bit can be linearly transformed into many information bit related bits, which are called check bits or redundant bits. These check bits are configured to recover the information bits that are flooded by a fading channel during decoding. Assuming that the information bit is x, which is known at the sender and unknown at the receiver, apart from sending information bits, the sender also introduces the check bits p. The specific relationship is: how the sender gets p when the vector of the check matrix H multiplied by W=[x p] cascade is 0, and HW=0 can be configured to solve the equation. If the matrix H is designed in the lower triangle form adopted by 5G, the equation can be easily solved by using the check relation Hw=0, and this is the origin of check matrix. Since the matrix H is a necessary element, encoding can only be done on the premise of extending the base graph to the matrix H.

The function of the circulation coefficient is introduced as follows: different Zs use the same circular coefficient, which in itself is a special constant function of circulation coefficient. For example, the circulation coefficient designed according to Z=256 is shift_coefficient. When Z=128, the circulation coefficient becomes mod (shift_coefficient, 128), ensuring that the circulation coefficient does not exceed the limit of Z.

The matrix obtained by replacing every 1 in the whole base graph of the LDPC matrix with the circulation coefficient of the corresponding sub-circular matrix is defined as protoMatrix.

Step 3: dispersion operation is conducted on the protoMatrix by using the circular factor Z to obtain a check matrix H of the LDPC.

wherein, the circulation coefficient of the protoMatrix is the circulation coefficient of the sub-circular matrix.

Step 4: encoding is performed according to the check matrix H of the LDPC determined in step 3.

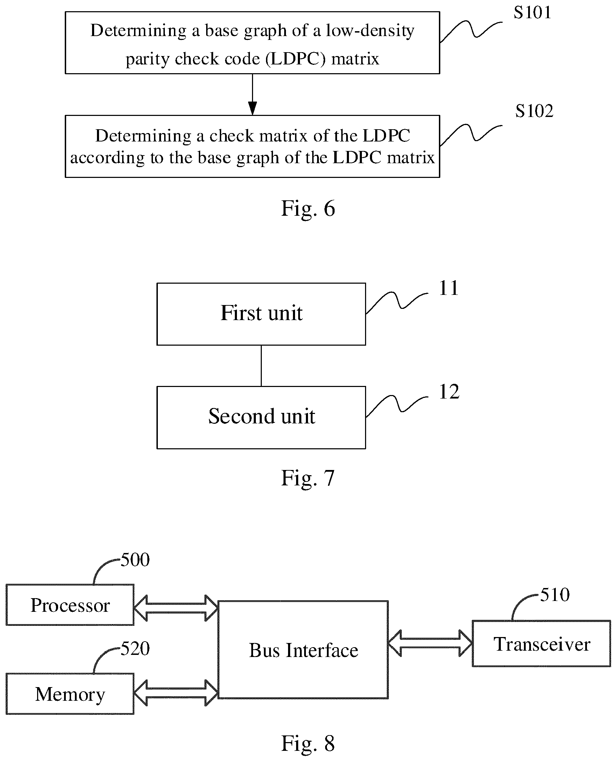

To sum up, referring to Fig. 6, a method for determining a check matrix provided in some embodiments of this application includes:

S101, determining a basic graph of a low-density parity check (LDPC) matrix;
S102, determining a check matrix of the LDPC according to the base graph of the LDPC matrix.

Optionally, the step of determining a check matrix of the LDPC according to the base graph of the LDPC matrix includes:

> determining the circulation coefficients of the sub-circular matrices according to the base graph of the LDPC matrix (that is, the above-mentioned step 2); conducting dispersion operation on the protoMatrix by using the circulation coefficients of the sub-circular matrices to obtain a check matrix of the LDPC (that is, the above-mentioned step 3).

Optionally, the step of determining a base graph of an LDPC matrix includes:
determining a base graph of an LDPC matrix according to the preset quantity of rows and columns (that is, the above-mentioned step 1).

Optionally, the base graph of the LDPC matrix includes base graphs with multiple code rates (such as the above-mentioned high code rate, medium-high code rate and low code rate), and the structures (such as a non-row orthogonal structure, a quasi-row orthogonal structure and a row orthogonal structure) of base graphs with different code rates are different.

Optionally, the step of determining a base graph of an LDPC matrix according to the preset quantity of rows and columns specifically includes:

> generating a base graph of a non-row orthogonal structure with preset row weight (e.g. the above-mentioned high row weight) according to the first code rate (e.g. the above-mentioned high code rate). generating a base graph of a quasi-row orthogonal structure by enabling the base graph of the non-row orthogonal structure to extend according to the second code rate;
> generating a base graph of a row orthogonal structure by enabling the base graph of the quasi-row orthogonal structure to extend according to the third code rate;
> constituting a base graph of an LDPC matrix satisfying the preset requirements of row number and column number by the base graph of the non-row orthogonal structure, the base graph of the quasi-row orthogonal structure and the base graph of the row orthogonal structure;
> wherein, the first code rate is larger than the second code rate, and the second code rate is larger than the third code rate.

It should be noted that all the specific values, such as the preset values, preset code rates, preset row weight, etc. described in the embodiments of this application can be determined according to actual needs, which are not limited by the embodiments of this application.

Corresponding to the above method, referring to Fig. 7, a device for determining a check matrix provided in some embodiments of the present application includes:

> a first unit 11, which is configured to determine a base graph of an LDPC matrix;
> a second unit 12, which is configured to determine a check matrix of the LDPC according to the base graph of the LDPC matrix.

Optionally, the second unit 12 is configured to:

> determine the circulation coefficients of the sub-circular matrices according to the base graph of the LDPC matrix;
> conduct dispersion operation on the protoMatrix by using the circulation coefficients of the sub-circular matrices to obtain a check matrix of the LDPC.

Optionally, the first unit 11 is configured to: determine a base graph of an LDPC matrix according to the preset quantity of rows and columns.

Optionally, the base graph of the LDPC matrix includes base graphs with multiple code rates, and base graphs with different code rates have different structures.

Optionally, the first unit 11 is configured to:

> generate a base graph of a non-row orthogonal structure with preset row weight according to the first code rate;
> generate a base graph of a quasi-row orthogonal structure by enabling the base graph of the non-row orthogonal structure to extend according to the second code rate;
> generate a base graph of a row orthogonal structure by enabling the base graph of the quasi-row orthogonal structure to extend according to the third code rate;
> constitute a base graph of an LDPC matrix satisfying the preset requirements of row number and column number by the base graph of the non-row orthogonal structure, the base graph of the quasi-row orthogonal structure and the base graph of the row orthogonal structure;
> wherein, the first code rate is larger than the second code rate, and the second code rate is larger than the third code rate.

In some embodiments of this application, both the first unit 11 and the second unit 12 described above can be implemented by physical devices such as processors.

Another encoding device provided in some embodiments of this application includes a memory and a processor, wherein the memory is configured to store program instructions and the processor is configured to read the program instructions stored in the memory to execute any of the above-mentioned methods according to the obtained programs.

For example, Fig. 8 shows another encoding device provided in some embodiments of this application, wherein a processor 500 is configured to read programs in a memory 520 and perform the following procedures:

determining a base graph of an LDPC matrix;
determining a check matrix of the LDPC according to the base graph of the LDPC matrix.

Optionally, the determining a check matrix of the LDPC according to the base graph of the LDPC matrix by the processor 500 includes:

determining the circulation coefficients of the sub-circular matrices according to the base graph of the LDPC matrix by the processor 500.
conducting dispersion operation on the protoMatrix by using the circulation coefficients of the sub-circular matrices to obtain a check matrix of the LDPC by the processor 500.

Optionally, the determining a base graph of an LDPC matrix by the processor 500 includes:
determining a base graph of an LDPC matrix according to the preset quantity of rows and columns by the processor 500.

Optionally, the base graph of the LDPC matrix includes base graphs with multiple code rates, and base graphs with different code rates have different structures.

Optionally, the determining a base graph of an LDPC matrix according to the preset quantity of rows and columns by the processor 500 includes:

generating a base graph of a non-row orthogonal structure with preset row weight according to the first code rate by the processor 500;
generating a base graph of a quasi-row orthogonal structure by enabling the base graph of the non-row orthogonal structure to extend according to the second code rate by the processor 500;
generating a base graph of a row orthogonal structure by enabling the base graph of the quasi-row orthogonal structure to extend according to the third code rate by the processor 500;
constituting a base graph of an LDPC matrix satisfying the preset quantity of rows and columns by the base graph of the non-row orthogonal structure, the base graph of the quasi-row orthogonal structure and the base graph of the row orthogonal structure;
wherein, the first code rate is larger than the second code rate, and the second code rate is larger than the third code rate.

The another encoding device also comprises a transceiver 510, which is configured to receive and send data under the control of the processor 500.

As shown in Fig. 8, the bus architecture may include any number of interconnected buses and bridges, which are specifically connected by one or more processors represented by the processor 500 and various circuits of memories represented by the memory 520. The bus architecture can also link various other circuits, such as peripheral units, regulators and power management circuits, which are well known in the field. Therefore, further description will not be included in this application. A bus interface provides interface. The transceiver 510 may comprise a plurality of components, i.e., a transmitter and a transceiver, to provide a unit for communicating with various other devices on the transmission medium. The processor 500 is responsible for managing bus architecture and general processing. The memory 520 can store data that are used by the processor 500 in performing operations.

The processor 500 may be a Central Processing Unit (CPU), Application Specific Integrated Circuit (ASIC), Field Programmable Gate Array (FPGA) or Complex Programmable Logic Device (CPLD).

The device for determining a check matrix provided in some embodiments of this application may also be regarded as a computing device, which can specifically be a desktop computer, a portable computer, a smart phone, a tablet computer, a Personal Digital Assistant (PDA), etc. The computing device may include a Center Processing Unit (CPU), memory, input/output devices, etc., wherein the input devices may include keyboard, mouse, touch screen and so on, and the output devices may include display devices, such as Liquid Crystal Display (LCD), Cathode Ray Tube (CRT), etc.

Memories may include Read Only Memory (ROM) and Random Access Memory (RAM), and provide program instructions and data stored in the memory to the processor. In the present application embodiment, the memory may be configured to store programs of encoding methods.

By reading program instructions stored in the memory, the processor is configured to perform the above encoding method according to the obtained program instructions.

The method for determining a check matrix provided in some embodiments of this application may be applied to terminal devices or network devices.

The terminal equipment may also be called User Equipment (UE), Mobile Station (MS), Mobile Terminal, etc. Optionally, the terminal may have the ability of communicating with one or more core networks through Radio Access Network (RAN). For example, the terminal may be a mobile phone (or "cellular" phone), or a computer with mobile nature. For example, the terminal may also be a portable, pocket, handheld, computer built-in or vehicle-mounted mobile device.

The network device may be a base station (for example, an access point), referring to device in the access network that communicates with the wireless terminal through one or more sectors on the air interface. The base station may be configured to convert the received air frame and the IP packets into each other as a router between the wireless terminal and the rest parts of the access network. The rest parts of the access network may include Internet Protocol (IP) network. The base station may also coordinate the attribute management of the air interface. For example, the base station may be a base station (BTS, Base Transceiver Station) in GSM or CDMA, or a base station (NodeB) in WCDMA, or an evolutional base station (NodeB or eNB or e-NodeB, evolutional Node B) in LTE, which are not limited in the embodiments of the present application.

A computer storage medium provided in some embodiments of the present application is configured to store computer program instructions for the above-mentioned computing device, which includes programs for executing the above-mentioned encoding method.

The computer storage medium may be any available medium or data storage device that the computer can access, including but not limited to magnetic memory (such as floppy disk, hard disk, magnetic tape, magneto-optical disk (MO)), optical memory (such as CD, DVD, BD, HVD, etc.), and semiconductor memory (such as ROM, EPROM, EEPROM, non-volatile memory (NAND FLASH), solid-state hard disk (SSD)) and so on.

To sum up, in the technical solution provided in some embodiments of this application, high row weight at the high code rate part is maintained, high code rate performance is ensured by non-row orthogonality, and at the same time, high throughput can be achieved due to the low complexity of high code rate; the high code rate extended medium code rate parts adopt a quasi-row orthogonal structure, and the quasi-row orthogonality ensures the density of non-zero elements in the first two columns of the check matrix to guarantee the priority of performance. At the same time, maintaining of row orthogonality of other elements in rows beside those with in-between built-in punching columns is conducive to high throughput. A feasible method can adopt the previous iteration likelihood ratio at the location of the built-in punching columns, and deal with quasi-row orthogonal rows according to the implementation of row orthogonality; adopting of a complete row orthogonal design on low code rate will reduce the dependence of the low code rate part on the built-in punching columns. Using of a row orthogonal design will not cause significant loss of the system performance, but speed up the encoding of those with low code rate and reduce latency. Therefore, the technical solution provided in some embodiments of this application integrates non-row orthogonal, quasi-row orthogonal and row orthogonal design solutions, and is very suitable for 5G eMBB and URLLC scenarios requiring high throughput and low latency.

Those skilled in the art should understand that embodiments of this application may be provided as methods, systems, or computer program products. Therefore, the present application may take the form of full hardware embodiments, full software embodiments, or embodiments in combination with software and hardware. Furthermore, the present application may take the form of computer program product that implemented on one or more computer available storage media (including but not limited to disk memory, CD-ROM, optical memory, etc.) containing computer available program codes.

The present application is described with reference to a method, device (system), and a flowchart and/or block diagram of a computer program product according to embodiments of the present application. It should be understood that each flow and/or block in flowchart and/or block diagram, and the combination of flow and/or block in the flowchart and/or the block diagram, can be implemented by computer program instructions. These computer program instructions can be provided to general purpose computers, special purpose computers, embedded processors or other processors of programmable data processing devices to generate a machine, so as to generate a device to realize functions specified in one or more flows in the flowchart and/or one or more blocks in the block diagram by instructions executed by a computer or other processors of programmable data processing devices.

These computer program instructions may also be stored in a computer-readable memory that may guide a computer or other programmable data processing devices to work in a specific way, so that instructions stored in the computer-readable memory can produce manufactures including instruction devices, which are implemented to realize functions specified in one or more flows in the flowchart and/or one or more blocks in the block diagram.

These computer program instructions can also be loaded on a computer or other programmable data processing devices, enabling a series of operational steps to be performed on the computer or other programmable devices to produce computer-implementing processing, thus instructions executed on the computer or other programmable devices can provide steps of functions specified in one or more flows in the flowchart and/or one or more blocks in the block diagram.

Although preferred embodiments of the present application have been described, once learned the basic creative concepts, those skilled in the art may make additional changes and modifications to these embodiments. Therefore, the appended claims are intended to be interpreted as including preferred embodiments and all changes and modifications falling within the scope of this application.

Obviously, those skilled in the art may make various changes and variations to the embodiments of the present application without departing from the spirit and scope of the embodiments of the present application. Thus, these modifications and variations to the embodiments of the present application falling within the scope of the claims of the present application and their equivalent technologies are also included in the present application.

## Claims

1. A method for determining a check matrix, comprising:

   determining a base graph of a low-density parity check code (LDPC) matrix;
   determining a check matrix of the LDPC according to the base graph of the LDPC matrix.

2. The method according to claim 1, wherein the determining a check matrix of the LDPC according to the base graph of the LDPC matrix includes:

   determining circulation coefficients of a sub-circular matrices according to the base graph of the LDPC matrix.
   conducting a dispersion operation on a protoMatrix by using the circulation coefficients of the sub-circular matrices to obtain a check matrix of the LDPC.

3. The method according to claim 1, wherein the determining a base graph of an LDPC matrix includes:
   determining a base graph of an LDPC matrix according to a preset quantity of rows and columns.

4. The method according to claim 3, wherein the base graph of the LDPC matrix includes base graphs with multiple code rates, and base graphs with different code rates have different structures.

5. The method according to claim 4, wherein the determining a base graph of an LDPC matrix according to the preset quantity of rows and columns includes:

   generating a base graph of a non-row orthogonal structure with a preset row weight according to a first code rate;
   generating a base graph of a quasi-row orthogonal structure by enabling the base graph of the non-row orthogonal structure to extend according to a second code rate;
   generating a base graph of a row orthogonal structure by enabling the base graph of the quasi-row orthogonal structure to extend according to a third code rate;
   constituting a base graph of an LDPC matrix satisfying preset requirements of row number and column number by the base graph of the non-row orthogonal structure, the base graph of the quasi-row orthogonal structure and the base graph of the row orthogonal structure;
   wherein, the first code rate is larger than the second code rate, and the second code rate is larger than the third code rate.

6. The method according to claim 5, wherein in the base graph, a row weight of all rows in the base graph corresponding to the bidiagonal matrix is greater than or equal to a preset value.

7. A device for determining a check matrix, comprising:

   a first unit configured to determine a base graph of an LDPC matrix.
   a second unit configured to determine a check matrix of the LDPC according to the base graph of the LDPC matrix.

8. The device according to claim 7, wherein the second unit is configured to:

   determine circulation coefficients of sub-circular matrices according to the base graph of the LDPC matrix;
   conduct a dispersion operation on the protoMatrix by using the circulation coefficients of the sub-circular matrices to obtain a check matrix of the LDPC.

9. The device according to claim 7, wherein the first unit is configured to:
   determine a base graph of an LDPC matrix according to a preset quantity of rows and columns.

10. The device according to claim 9, wherein the base graph of the LDPC matrix includes base graphs with multiple code rates, and base graphs with different code rates have different structures.

11. The device according to claim 10, wherein the first unit is configured to:

    generate a base graph of a non-row orthogonal structure with a preset row weight according to a first code rate;
    generate a base graph of a quasi-row orthogonal structure by enabling the base graph of the non-row orthogonal structure to extend according to a second code rate;
    generate a base graph of a row orthogonal structure by enabling the base graph of the quasi-row orthogonal structure to extend according to a third code rate;
    constitute a base graph of an LDPC matrix satisfying preset requirements of row number and column number by the base graph of the non-row orthogonal structure, the base graph of the quasi-row orthogonal structure and the base graph of the row orthogonal structure;
    wherein, the first code rate is larger than the second code rate, and the second code rate is larger than the third code rate.

12. The device according to claim 11, wherein in the base graph, a row weight of all rows in the base graph corresponding to the bidiagonal matrix is greater than or equal to a preset value.

13. A device for determining a check matrix, comprising:

   a memory configured to store program instructions;
   a processor configured to read the program instructions stored in the memory to: determine a base graph of an LDPC matrix; determine a check matrix of the LDPC according to the base graph of the LDPC matrix.

14. An encoding method, comprising:
   encoding according to a check matrix of the LDPC; wherein the check matrix of the LDPC is determined by the method for determining a check matrix provided in any one of claims 1-6.

15. An encoding device, comprising:
   an encoding unit configured to encoding according to a check matrix of the LDPC; wherein, the check matrix of the LDPC is determined by the method for determining a check matrix provided in any one of claims 1 to 6.

16. A computer storage medium, wherein the computer storage medium stores computer executable instructions for enabling a computer to perform the method provided in any one of claims 1 to 6, and claim 14.

$$B = \begin{bmatrix} 1 & 0 & \cdots & 1 \\ 0 & 1 & \cdots & 1 \\ \vdots & \vdots & \ddots & \vdots \\ 1 & 1 & \cdots & 0 \end{bmatrix}_{\rho \times c}$$

Fig. 1

$$P = \begin{bmatrix} 0 & 1 & 0 & \cdots & 0 \\ 0 & 0 & 1 & \cdots & 0 \\ \vdots & \vdots & \vdots & \vdots & \vdots \\ 0 & 0 & 0 & \cdots & 1 \\ 1 & 0 & 0 & \cdots & 0 \end{bmatrix}_{z \times z}$$

Fig. 2

$$P^0 = \begin{bmatrix} 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & 1 \end{bmatrix}, P = P^1 = \begin{bmatrix} 0 & 1 & 0 & 0 & 0 & 0 & 0 & 0 \\ 0 & 0 & 1 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \\ 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & 1 \\ 1 & 0 & 0 & 0 & 0 & 0 & 0 & 0 \end{bmatrix}, P^5 = \begin{bmatrix} 0 & 0 & 0 & 0 & 0 & 1 & 0 & 0 \\ 0 & 0 & 0 & 0 & 0 & 0 & 1 & 0 \\ 0 & 0 & 0 & 0 & 0 & 0 & 0 & 1 \\ 1 & 0 & 0 & 0 & 0 & 0 & 0 & 0 \\ 0 & 1 & 0 & 0 & 0 & 0 & 0 & 0 \\ 0 & 0 & 1 & 0 & 0 & 0 & 0 & 0 \\ 0 & 0 & 0 & 1 & 0 & 0 & 0 & 0 \\ 0 & 0 & 0 & 0 & 1 & 0 & 0 & 0 \end{bmatrix}$$

Fig. 3

Fig. 4

| | 1 | 2 | 3 | 4 | 5 | 6 | 7 | 8 | 9 | 10 | 11 | 12 | 13 | 14 | 15 | 16 | 17 | 18 | 19 | 20 | 21 | 22 | 23 | 24 | 25 | 26 | 27 | 28 | 29 | 30 | 31 | 32 |
|---|---|---|---|---|---|---|---|---|---|----|----|----|----|----|----|----|----|----|----|----|----|----|----|----|----|----|----|----|----|----|----|----|
| 1 | 1 | 1 | 1 | 0 | 1 | 0 | 0 | 0 | 1 | 1 | 1 | 1 | 1 | 0 | 0 | 0 | 0 | 0 | 0 | 0 | 0 | 0 | 0 | 0 | 0 | 0 | 0 | 0 | 0 | 0 | 0 | 0 |
| 2 | 0 | 1 | 1 | 1 | 1 | 1 | 1 | 1 | 1 | 0 | 0 | 1 | 1 | 0 | 0 | 0 | 0 | 0 | 0 | 0 | 0 | 0 | 0 | 0 | 0 | 0 | 0 | 0 | 0 | 0 | 0 | 0 |
| 3 | 1 | 1 | 0 | 0 | 0 | 1 | 0 | 1 | 1 | 0 | 1 | 0 | 1 | 1 | 0 | 0 | 0 | 0 | 0 | 0 | 0 | 0 | 0 | 0 | 0 | 0 | 0 | 0 | 0 | 0 | 0 | 0 |
| 4 | 1 | 0 | 1 | 1 | 1 | 1 | 1 | 0 | 1 | 1 | 1 | 0 | 0 | 1 | 0 | 0 | 0 | 0 | 0 | 0 | 0 | 0 | 0 | 0 | 0 | 0 | 0 | 0 | 0 | 0 | 0 | 0 |
| 5 | 0 | 1 | 0 | 1 | 0 | 0 | 1 | 0 | 0 | 0 | 0 | 0 | 0 | 1 | 1 | 0 | 0 | 0 | 0 | 0 | 0 | 0 | 0 | 0 | 0 | 0 | 0 | 0 | 0 | 0 | 0 | 0 |
| 6 | 1 | 1 | 0 | 0 | 0 | 0 | 0 | 1 | 0 | 0 | 1 | 0 | 0 | 1 | 0 | 1 | 0 | 0 | 0 | 0 | 0 | 0 | 0 | 0 | 0 | 0 | 0 | 0 | 0 | 0 | 0 | 0 |
| 7 | 1 | 1 | 0 | 0 | 0 | 0 | 1 | 0 | 0 | 0 | 0 | 0 | 0 | 1 | 0 | 0 | 1 | 0 | 0 | 0 | 0 | 0 | 0 | 0 | 0 | 0 | 0 | 0 | 0 | 0 | 0 | 0 |
| 8 | 1 | 1 | 0 | 1 | 0 | 0 | 0 | 0 | 1 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 |
| 9 | 0 | 1 | 0 | 0 | 0 | 0 | 0 | 0 | 0 | 0 | 0 | 0 | 0 | 1 | 0 | 0 | 0 | 0 | 1 | 0 | 0 | 0 | 0 | 0 | 0 | 0 | 0 | 0 | 0 | 0 | 0 | 0 |
| 10 | 1 | 0 | 0 | 0 | 1 | 0 | 0 | 0 | 0 | 0 | 1 | 0 | 0 | 0 | 1 | 0 | 0 | 0 | 0 | 1 | 0 | 0 | 0 | 0 | 0 | 0 | 0 | 0 | 0 | 0 | 0 | 0 |
| 11 | 1 | 0 | 0 | 1 | 0 | 1 | 0 | 0 | 0 | 0 | 0 | 0 | 1 | 0 | 0 | 0 | 0 | 0 | 0 | 0 | 1 | 0 | 0 | 0 | 0 | 0 | 0 | 0 | 0 | 0 | 0 | 0 |
| 12 | 1 | 1 | 0 | 0 | 0 | 0 | 1 | 1 | 0 | 0 | 0 | 0 | 0 | 0 | 0 | 0 | 0 | 0 | 0 | 0 | 0 | 1 | 0 | 0 | 0 | 0 | 0 | 0 | 0 | 0 | 0 | 0 |
| 13 | 1 | 0 | 0 | 0 | 0 | 1 | 0 | 0 | 0 | 0 | 0 | 1 | 0 | 0 | 0 | 0 | 0 | 0 | 0 | 0 | 0 | 0 | 1 | 0 | 0 | 0 | 0 | 0 | 0 | 0 | 0 | 0 |
| 14 | 0 | 1 | 0 | 1 | 0 | 0 | 0 | 0 | 1 | 0 | 0 | 0 | 0 | 0 | 0 | 0 | 0 | 0 | 0 | 0 | 0 | 0 | 0 | 1 | 0 | 0 | 0 | 0 | 0 | 0 | 0 | 0 |
| 15 | 1 | 0 | 1 | 0 | 0 | 0 | 0 | 1 | 0 | 0 | 0 | 0 | 0 | 0 | 0 | 0 | 0 | 0 | 0 | 0 | 0 | 0 | 0 | 0 | 1 | 0 | 0 | 0 | 0 | 0 | 0 | 0 |
| 16 | 0 | 1 | 0 | 0 | 0 | 0 | 1 | 0 | 0 | 0 | 0 | 1 | 0 | 0 | 0 | 0 | 0 | 0 | 0 | 0 | 0 | 0 | 0 | 0 | 0 | 1 | 0 | 0 | 0 | 0 | 0 | 0 |
| 17 | 1 | 0 | 0 | 0 | 0 | 1 | 0 | 0 | 0 | 0 | 0 | 0 | 0 | 1 | 0 | 0 | 0 | 0 | 0 | 0 | 0 | 0 | 0 | 0 | 0 | 0 | 1 | 0 | 0 | 0 | 0 | 0 |
| 18 | 0 | 1 | 0 | 0 | 0 | 0 | 0 | 0 | 0 | 0 | 1 | 0 | 1 | 0 | 0 | 0 | 0 | 0 | 0 | 0 | 0 | 0 | 0 | 0 | 0 | 0 | 0 | 1 | 0 | 0 | 0 | 0 |
| 19 | 1 | 0 | 0 | 0 | 1 | 0 | 0 | 0 | 0 | 1 | 0 | 0 | 0 | 0 | 0 | 0 | 0 | 0 | 0 | 0 | 0 | 0 | 0 | 0 | 0 | 0 | 0 | 0 | 1 | 0 | 0 | 0 |
| 20 | 0 | 1 | 0 | 0 | 0 | 1 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 1 | 0 | 0 |
| 21 | 1 | 0 | 0 | 0 | 0 | 0 | 0 | 1 | 0 | 0 | 0 | 1 | 0 | 0 | 0 | 0 | 0 | 0 | 0 | 0 | 0 | 0 | 0 | 0 | 0 | 0 | 0 | 0 | 0 | 0 | 1 | 0 |
| 22 | 0 | 1 | 1 | 0 | 0 | 0 | 0 | 0 | 0 | 0 | 0 | 1 | 0 | 0 | 0 | 0 | 0 | 0 | 0 | 0 | 0 | 0 | 0 | 0 | 0 | 0 | 0 | 0 | 0 | 0 | 0 | 1 |

Fig. 5

Determining a base graph of a low-density parity check code (LDPC) matrix — S101

Determining a check matrix of the LDPC according to the base graph of the LDPC matrix — S102

Fig. 6

First unit — 11

Second unit — 12

Fig. 7

Processor — 500

Memory — 520

Bus Interface

Transceiver — 510

Fig. 8

## INTERNATIONAL SEARCH REPORT

| International application No. |
|---|
| PCT/CN2018/083957 |

### A. CLASSIFICATION OF SUBJECT MATTER

H03M 13/15 (2006.01) i; H03M 13/11 (2006.01) i

According to International Patent Classification (IPC) or to both national classification and IPC

### B. FIELDS SEARCHED

Minimum documentation searched (classification system followed by classification symbols)

H03M; H04L

Documentation searched other than minimum documentation to the extent that such documents are included in the fields searched

Electronic data base consulted during the international search (name of data base and, where practicable, search terms used)

CNPAT; EPODOC; WPI; CNKI; IEEE; GOOGLE: 王加庆, 张获, 孙韶辉, 电信科学技术研究院, 低密度奇偶校验, LDPC, 基础图, 基础矩阵, 原模图, 原模矩阵, 码率, 生成, 得到, 构造, 构建, 构成, 获得, 扩展, 增加, 矩阵, 循环, 移位, 替换, 代替, 散列, code 10d rate, basic, base, proto, matrix, graph, circular+, circulation, shift, replace, take, substitute, displace, substitution, hash, extend, add

### C. DOCUMENTS CONSIDERED TO BE RELEVANT

| Category* | Citation of document, with indication, where appropriate, of the relevant passages | Relevant to claim No. |
|---|---|---|
| X | CN 104158550 A (CHONGQING UNIVERSITY OF POSTS AND TELECOMMUNICATIONS), 19 November 2014 (19.11.2014), abstract, description, paragraphs [0006]-[0068], and figure 3 | 1, 3-4, 7, 9-10, 13-16 |
| A | CN 104158550 A (CHONGQING UNIVERSITY OF POSTS AND TELECOMMUNICATIONS), 19 November 2014 (19.11.2014), entire document | 2, 5-6, 8, 11-12 |
| X | CN 1808955 A (ZTE CORP.), 26 July 2006 (26.07.2006), description, page 10, line 26 to page 19, line 6 | 1, 3-4, 7, 9-10, 13-16 |
| A | CN 1808955 A (ZTE CORP.), 26 July 2006 (26.07.2006), entire document | 2, 5-6, 8, 11-12 |
| X | US 2011307756 A1 (NGUYEN, T. V. et al.), 15 December 2011 (15.12.2011) figure 8, description, paragraphs [0007], [0018]-[0019] and [0055] | 1, 3-4, 7, 9-10, 13-16 |
| A | US 2011307756 A1 (NGUYEN, T. V. et al.), 15 December 2011 (15.12.2011), entire document | 2, 5-6, 8, 11-12 |

☐ Further documents are listed in the continuation of Box C. ☒ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 02 July 2018 | 19 July 2018 |

| Name and mailing address of the ISA | Authorized officer |
|---|---|
| State Intellectual Property Office of the P. R. China No. 6, Xitucheng Road, Jimenqiao Haidian District, Beijing 100088, China Facsimile No. (86-10) 62019451 | NING, Bo Telephone No. 86-(10)-53961584 |

Form PCT/ISA/210 (second sheet) (January 2015)

## INTERNATIONAL SEARCH REPORT
Information on patent family members

International application No.

PCT/CN2018/083957

| Patent Documents referred in the Report | Publication Date | Patent Family | Publication Date |
|---|---|---|---|
| CN 104158550 A | 19 November 2014 | None | |
| CN 1808955 A | 26 July 2006 | EP 1850484 A1 | 31 October 2007 |
| | | WO 2006076834 A1 | 27 July 2006 |
| | | US 2008168324 A1 | 10 July 2008 |
| US 2011307756 A1 | 15 December 2011 | WO 2012039798 A2 | 29 March 2012 |

Form PCT/ISA/210 (patent family annex) (January 2015)

**EP 3 633 858 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 201710401631